# EUROPÄISCHE PATENTANMELDUNG

(11) **EP 2 844 044 A1**
(43) Veröffentlichungstag der Anmeldung: **04.03.2015**
(21) Anmeldenummer: 13182810.5
(22) Anmeldetag: 03.09.2013
(51) Int. Cl.: H05K 3/12, H05K 3/40

(54) **Anlage und Verfahren zum Füllen von Löchern in einer Leiterplatte**

(71) Anmelder: Mass GmbH, 59590 Geseke (DE)
(72) Erfinder: Potthast, Thomas, 33098 Paderborn (DE)
(74) Vertreter: Reimann, Silke

(57) **Zusammenfassung**

Die Erfindung bezieht sich auf eine Anlage und ein Verfahren zum Füllen von Löchern (10, 19) in einer Leiterplatte mit einem Füllmaterial (9), umfassend eine Haltevorrichtung (4) zum Halten der Leiterplatte (6), ein Füllteil (8), das über die Leiterplatte (6) bewegbar ist und aus dem das Füllmaterial (9) in die Löcher (10, 19) einbringbar ist, wobei das Füllteil (8) als Mikrodosiereinrichtung ausgeführt ist, die mit einer Positioniereinrichtung (5) über einem zu füllenden Loch (10) positionierbar ist und aus einer Düse (11) Mikrotropfen einer Paste als Füllmaterial (9) in das Loch (10) abgibt.

## Beschreibung

Die Erfindung betrifft eine Anlage und ein Verfahren zum Füllen von Löchern in einer Leiterplatte mit einem Füllmaterial umfassend eine Haltevorrichtung zum Halten der Leiterplatte ein Füllteil das über die Leiterplatte bewegbar ist und aus dem das Füllmaterial in die Löcher eingebracht wird.

Bei der Herstellung von mehrschichtigen Leiterplatten werden in diesen zur Kontaktherstellung zwischen den einzelnen Schichten Löcher ausgebildet, welche dann mit einem leitfähigen Material ausgefüllt werden oder zur Einsparung eines solchen Materials z. B. nur an ihren Umfangswänden metallisch beschichtet und anschließend mit kostengünstigerem Material, wie z. B. Epoxidharz, wieder verschlossen werden. Das Schließen der Löcher wird vorgenommen, um die Gesamtfläche zu minimieren. So können z. B. auf einer wieder aufgefüllten Bohrung Anlötsockel Pads für an die Leiterplatte anzuschließende Bauteile, wie z. B. Transistoren, ICs etc., angeordnet werden. Es kann auch ein Loch in einer Zwischenlage genutzt werden, um eine elektrische Verbindung beider Seiten dieser Zwischenlage herzustellen, wobei dann nach dem Verfüllen dieses Lochs die gleiche Fläche für eine kleinere Bohrung wieder benutzt werden kann, um beispielsweise eine Kontaktverbindung zwischen weiter außen gelegenen Leiterplattenlagen herzustellen.

Aus der Patentschrift DE 102 22 874 B4 ist eine Füllanlage zum luftblasenfreien Füllen von in Leiterplatten eingebrachten Löchern mit einem Füllmaterial bekannt. Die dort beschriebene Füllanlage füllt die Löcher einer vertikal gehaltenen Leiterplatte mit einem Füllkopf und einem auf der gegenüberliegenden Seite der Leiterplatte befindlichen Abstreifrakel. Das Füllen erfolgt grundsätzlich unter Vakuum

Aus der Patentanmeldung US 2003/170387 A1 ist eine Anlage zum Bearbeiten von Leiterplatten bekannt, die das Füllen von Löchern einer waagerecht liegenden Leiterplatte mit einem Füllmaterial über Pressdruck durch eine Schablone erlaubt. Als Gegenhalteteil beim Füllen ist nur ein Rakel vorgesehen, so dass sich die Leiterplatte durch den Pressdruck durchbiegen und damit die Füllung an Präzision verlieren kann.

Aus der Patentschrift EP 2 421 343 B1 ist eine Füllanlage zum luftblasenfreien Füllen von in Leiterplatten eingebrachten Löchern mit einem Füllmaterial bekannt. Diese Füllanlage füllt die Löcher in einer horizontal gehaltenen Leiterplatte und einer darauf liegenden Schablone mit einem abdichtenden Füllkopf.

Es ist die Aufgabe der Erfindung, eine Anlage zu offenbaren, die es erlaubt die Löcher einer Leiterplatte blasenfrei zu füllen ohne dass eine Schablone genutzt werden muss.

Diese Aufgabe wird durch eine Anlage mit den Merkmalen des Anspruchs 1 gelöst. Ein Verfahren zum Bearbeiten einer Leiterplatte mit einer solchen Anlage ist in Anspruch 6 beschrieben. Vorteilhafte Ausgestaltungen der Erfindung sind in den abhängigen Ansprüchen angegeben.

Die Anlage zum Füllen von Löchern in einer Leiterplatte mit einem Füllmaterial umfasst eine Haltevorrichtung zum waagerechten Halten der Leiterplatte und ein Füllteil, das über die Leiterplatte bewegbar ist. Aus dem Füllteil ist das Füllmaterial in die Löcher einbringbar.

Die Anlage zeichnet sich dadurch aus, dass das Füllteil als Mikrodosiereinrichtung ausgeführt ist, die mit einer Positioniereinrichtung über einem zu füllenden Loch positionierbar ist und aus einer Düse Mikrotropfen einer Paste als Füllmaterial in das Loch abgibt.

Die Mikrotropfen der Paste sind durch die Mikrodosiereinrichtung so fein dosiert, dass sie das Loch in der Leiterplatte auffüllen und die Luft dort verdrängen. Es wird auf diese Weise das Loch blasenfrei verfüllt.

Durch den Zwang zur Miniaturisierung von elektronischen Geräten werden die Löcher in Leiterplatten immer kleiner ausgeführt. Die mit der hier vorgeschlagenen Anlage zu füllenden Löcher können einen minimalen Durchmesser von 0,2 mm besitzen.

Die Paste als Füllmaterial besitzt eine Partikelgröße von kleiner 15 µm und eine Viskosität kleiner 40 Pas. Mit diesen Parametern kann das Füllmaterial so fein dosiert werden, dass sich Mikrotropfen mit 3 nl Inhalt ergeben. Diese Mikrotropfen besitzen einen solchen geringen Durchmesser, dass die Luft in dem Loch verdrängt wird.

Das Füllmaterial kann eine leitfähige Füllmasse, wie z. B. eine Silberpaste, sein. Bevorzugt werden jedoch elektrisch isolierend Pasten, etwa auf Epoxydharzbasis, als Füllmaterial genutzt.

Das Füllteil wird motorisch angetrieben und mit seiner Düse genau über einem zu füllenden Loch in der Leiterplatte positioniert. Das Loch kann dabei eine Durchgangsbohrung oder auch ein Sackloch sein.

Das Verfahren zum Füllen von Löchern in Leiterplatten mit einem Füllmaterial mittels einer Anlage wie vorbeschriebenen sieht vor, dass das Füllteil über der Leiterplatte über einem zu füllenden Loch positioniert wird, aus der Düse der Mikrodosiereinrichtung unter Druck Mikrotropfen in das Loch solange abgegeben werden, bis Loch blasenfrei gefüllt ist, und dann weitere Löcher der Leiterplatte auf die gleiche Weise gefüllt werden.

Dabei sind die Bohrung der Düse und der Druck in der Mikrodosiereinrichtung so gewählt, dass sich Mikrotropfen mit etwa 3 nl Paste ergeben.

Die Abgabe von Mikrotropfen aus der Düse in ein Loch erfolgt vorzugsweise mit einem Intervall von 0,02 sec. So werden die Löcher der Leiterplatte schnell gefüllt.

Nach dem Füllen der Löcher wird die Leiterplatte getrocknet und das Füllmaterial härtet aus. Nach dem Trocknen überstehendes Füllmaterial wird abgeschliffen und die Oberfläche der Leiterplatte plan geschliffen. Damit kann dann die leiterplatte weiter verarbeitet werden, in dem z.B. auf die gefüllten Löcher Lötpads oder Klebepads für elektronische Bauelemente aufgebracht werden.

Die Erfindung wird im Folgenden anhand bevorzugter Ausführungsbeispiele mit Bezugnahme auf die Zeichnung erläutert. In der Zeichnung zeigen:
Fig. 1 eine schematische Darstellung einer Bearbeitungsanlage von Leiterplatten,
Fig. 2 einen Schnitt durch eine Leiterplatte mit Füllteil über einem gefüllten Loch.

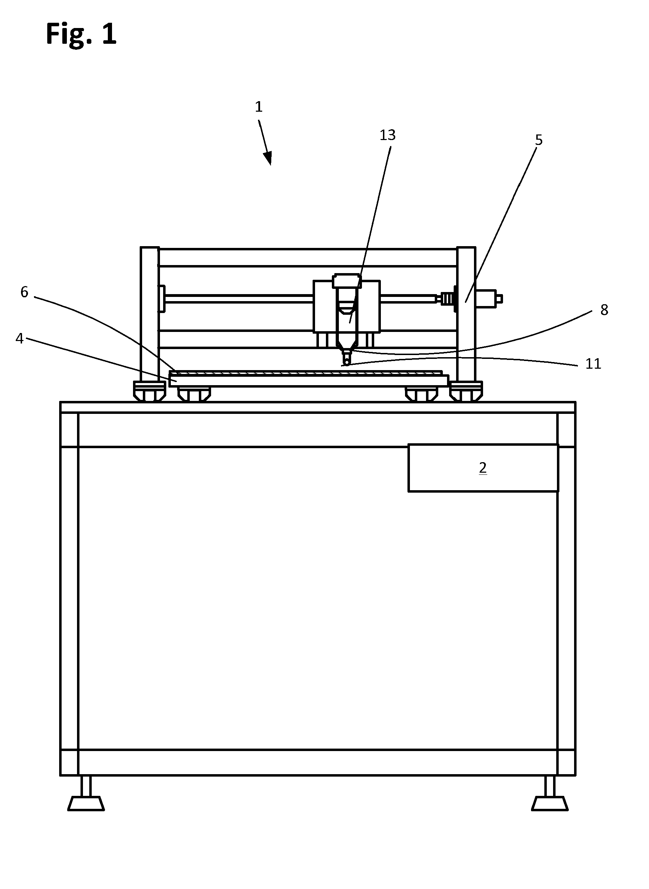

In Fig. 1 ist die Füllanlage 1 auf einem Arbeitstisch gezeigt, die mit einer Halteeinrichtung 4 für die Leiterplatte 6 ausgestattet ist, über der mittels der Positioniereinrichtung 5 das Füllteil 8 mit seiner Düse 11 über einem zu füllenden Loch positioniert wird.

In das Füllteil 8 wird aus der Kartusche 13 das Füllmaterial gepresst und dann in Form von Mikrotropfen in das Loch gefüllt.

Die Steuerung 2 übernimmt alle Steuervorgänge für die Bearbeitung, wie Positionieren des Füllteils 8, Aufbringen des Pressdrucks in der Kartusche 9, Abgabe der Mikrotropfen aus der Düse 11.

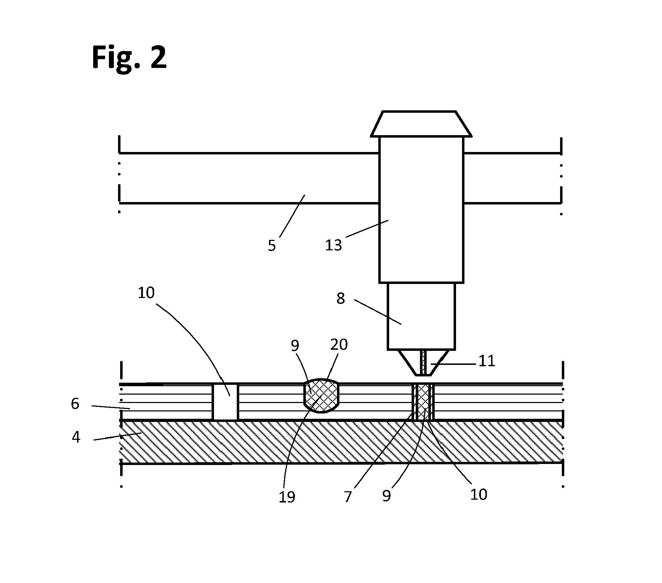

In Fig. 2 ist ein Ausschnitt einer Leiterplatte 6 auf der Haltevorrichtung 4 dargestellt. Das Füllteil 8 ist als Mikrodosiereinrichtung ausgeführt und wird mittels der Positioniereinrichtung 5 über den zu füllenden Löchern 10, 19 positioniert.

In der Leiterplatte 6 befinden sich Durchgangslöcher 10 und oder Sacklöcher 19. Diese Löcher 10, 19 können unterschiedlich groß sein und auch mit einer Metallisierung 7 versehen sein.

Auf dem Füllteil 8 befindet sich eine Kartusche 13, aus der das Füllmaterial 9 in die Düse 11 gepresst wird. Aus dieser werden Mikrotropfen in schneller Folge in die Löcher 10, 19 abgegeben.

Bei der Aushärtung des Füllmaterials kann das getrocknete Füllmaterial 20 einen Kegel oder ähnliches bilden, was dann in einer Nachbearbeitung plan abgeschliffen wird.

Auf den verfüllten Löchern 10, 19 können dann wieder elektronische

Bauelemente oder Leiterbahnen aufgebracht werden.

Mit dieser hier vorgestellten Füllanlage lassen sich auf relativ einfache Weise Löchern in Leiterplatten füllen, ohne dass es einer Schablone und/oder einer Vakuumeinrichtung bedarf.

### Bezugszeichenliste

- 1: Füllanlage
- 2: Steuerung
- 4: Haltevorrichtung
- 5: Positioniereinrichtung
- 6: Leiterplatte
- 7: Metallisierung
- 8: Füllteil
- 9: Füllmaterial
- 10: Loch
- 11: Düse
- 13: Kartusche
- 19: Sackloch
- 20: Getrocknetes Füllmaterial

## Patentansprüche

1. Anlage zum Füllen von Löchern (10, 19) in einer Leiterplatte mit einem Füllmaterial (9), umfassend eine Haltevorrichtung (4) zum Halten der Leiterplatte (6), ein Füllteil (8), das über die Leiterplatte (6) bewegbar ist und aus dem das Füllmaterial (9) in die Löcher (10, 19) einbringbar ist,
**dadurch gekennzeichnet, dass**
das Füllteil (8) als Mikrodosiereinrichtung ausgeführt ist, die mit einer Positioniereinrichtung (5) über einem zu füllenden Loch (10) positionierbar ist und aus einer Düse (11) Mikrotropfen einer Paste als Füllmaterial (9) in das Loch (10) abgibt.

2. Anlage nach Anspruch 1, **dadurch gekennzeichnet, dass** die Löcher (10) einen minimalen Durchmesser von 0,2 mm besitzen.

3. Anlage nach Anspruch 1, **dadurch gekennzeichnet, dass** die Paste eine Partikelgröße kleiner 15 µm und eine Viskosität kleiner 40 Pas besitzt.

4. Anlage nach Anspruch 1, **dadurch gekennzeichnet, dass** die Paste elektrisch isolierend ist.

5. Anlage nach Anspruch 1, **dadurch gekennzeichnet, dass** das Füllteil (8) motorisch in zwei Richtungen über einem Loch (10) der Leiterplatte (6) positionierbar ist.

6. Verfahren zum Füllen von Löchern (10, 19) in einer Leiterplatte (6) mit einem Füllmaterial (9) mittels einer Anlage (1) nach einem der vorstehenden Ansprüche, **dadurch gekennzeichnet, dass**
- das Füllteil (8) über der Leiterplatte (6) über einem zu füllenden Loch (10, 19) positioniert wird,
- aus der Düse (11) der Mikrodosiereinrichtung unter Druck Mikrotropfen in das Loch (10, 19) solange abgegeben werden, bis Loch (10, 19) blasenfrei gefüllt ist,
- und dann weitere Löcher (10, 19) der Leiterplatte (6) auf die gleiche Weise gefüllt werden.

7. Verfahren nach Anspruch 6, **dadurch gekennzeichnet, dass** ein Mikrotropfen etwa 3 nl Paste enthält.

8. Verfahren nach Anspruch 6, **dadurch gekennzeichnet, dass** die Abgabe von Mikrotropfen in ein Loch (10,19) mit einem Intervall von 0,02 sec erfolgt.

9. Verfahren nach Anspruch 6, **dadurch gekennzeichnet, dass** nach dem Füllen die Leiterplatte (6) getrocknet wird und das Füllmaterial (9) aushärtet.

10. Verfahren nach Anspruch 9, **dadurch gekennzeichnet, dass** überstehendes Füllmaterial (9) abgeschliffen und die Oberfläche der Leiterplatte (6) plan geschliffen wird.
